# EUROPÄISCHE PATENTSCHRIFT

(11) **EP 1 590 825 B1**
(45) Veröffentlichungstag und Bekanntmachung des Hinweises auf die Patenterteilung: **23.04.2008**
(21) Anmeldenummer: 04704570.3
(22) Anmeldetag: 23.01.2004
(51) Int. Cl.: H01J 37/317

(54) **VERFAHREN UND VORRICHTUNG ZUR HERSTELLUNG VON KORPUSKULARSTRAHLSYSTEMEN**
METHOD AND DEVICE FOR PRODUCING CORPUSCULAR RADIATION SYSTEMS
PROCEDE ET DISPOSITIF POUR PRODUIRE DES SYSTEMES A RAYONNEMENT CORPUSCULAIRE

(30) Priorität: 24.01.2003 DE 10302794
(43) Veröffentlichungstag der Anmeldung: 02.11.2005
(73) Patentinhaber: Koops, Hans W.P., Dr., 64372 Ober-Ramstadt (DE)
(72) Erfinder: Koops, Hans W.P., Dr., 64372 Ober-Ramstadt (DE)
(74) Vertreter: Borchert, Uwe Rudolf
(86) Internationale Anmeldenummer: PCT/EP2004/000559
(87) Internationale Veröffentlichungsnummer: WO 2004/066333

(56) Entgegenhaltungen:
- DE-A1- 4 435 043
- DE-A1- 19 609 234
- US-A- 5 145 438
- US-A- 5 267 884
- KOOPS H W P ET AL: "Miniature low voltage beam systems producable by combined lithographies" NUCLEAR INSTRUMENTS & METHODS IN PHYSICS RESEARCH, SECTION - A: ACCELERATORS, SPECTROMETERS, DETECTORS AND ASSOCIATED EQUIPMENT, NORTH-HOLLAND PUBLISHING COMPANY. AMSTERDAM, NL, Bd. A363, Nr. 1, 1995, Seiten 1-9, XP004009614 ISSN: 0168-9002
- KOOPS H W P ET AL: "Construction of a three-dimensional microtriode by nanolithography with electron-beam induced deposition" VACUUM MICROELECTRONICS CONFERENCE, 1996. IVMC'96., 9TH INTERNATIONAL ST. PETERSBURG, RUSSIA 7-12 JULY 1996, NEW YORK, NY, USA,IEEE, US, 7. Juli 1996 (1996-07-07), Seiten 458-462, XP010232233 ISBN: 0-7803-3594-5

## Beschreibung

Die Erfindung betrifft ein Verfahren zur Herstellung von Korpuskularstrahlsystemen gemäß der im Anspruch 1 angegebenen Art und eine entsprechende Vorrichtung gemäß der im Anspruch 20 angegebenen Art.

Korpuskularstrahlsysteme umfassen insbesondere Elektronenstrahl- oder Ionenstrahlsysteme. Im folgenden werden beispielhaft Elektronenstrahlsysteme, deren Anwendungen und Nachteile erläutert. Dies ist jedoch nicht einschränkend zu verstehen. Vielmehr gelten die folgenden Erläuterungen ebenso für andere Korpuskularstrahlsysteme wie beispielsweise die erwähnten Ionenstrahlsysteme.

Elektronenstrahlsysteme werden beispielsweise in der Halbleitertechnologie, Nanoanalytik, Bio-Nano-Physik, Mikro-Optik und Nano-Elektronik eingesetzt. Sie können insbesondere zur Herstellung von Nanostrukturen wie zum Beispiel der Elektronenstrahl-induzierten lithographischen Nanostrukturierung von Oberflächen angewandt werden. Ionen- und Elektronenstrahlsysteme werden auch zur Reparatur von Photomasken, phasenschiebenden Photomasken und NGL-Masken für die Halbleiterindustrie verwendet. Mit Elektronenstrahlen können auch integrierte Schaltungen direkt auf einen Halbleiterwafer geschrieben und auch dort repariert werden. Vorzugsweise wird dies bei integrierten Schaltungen mit Strukturabmessungen im nm-Bereich praktiziert, wo die bisher eingesetzte Optische und Ionenstrahl-Lithographie an physikalische Grenzen stößt.

Ein Elektronenstrahlsystem umfasst eine Vielzahl von elektronischen Komponenten, wie beispielsweise eine Strahlstromstabilisierung, eine Strahlablenkung, eine Fokusierungsautomatik mit Hilfe von programmierten Sequenzen, eine Elektronenstrahl-Ablenkung und - Verstärkung und eine Sekundärelektronenstrahlverstärkung. Diese Komponenten werden bisher überwiegend in Form von Einzelplatinen mit diskreten Schaltkreisen aufgebaut, die derart programmierbar sind, dass die vorgenannten Funktionen ausgeführt werden können.

Um Elektronenstrahlsysteme zu verkleinern, ist es bekannt, Einzelelemente von Elektronenstrahlsystemen mittels Elektronenstrahl-induzierter Deposition aufzubauen, wie beispielsweise der Aufbau von Feldelektronenemittern, Feldemissionskathoden mit Extraktor und Fokussierlinsen sowie von Drahtlinsen für eine elektrostatische Fokussierung und Ablenkung. Die Herstellung einer elektrostatischen Miniaturlinse mittels Elektronenstrahl-induzierter Deposition ist beispielsweise in der DE 44 35 043 A1 beschrieben.

Zur Miniaturisierung wurden Elektronenstrahlsysteme auch aus mechanischen Einzelteilen zusammengebaut, die aber nicht mit einer kalten Feldelektronenemission, sondern einer heißen Elektronenemission betrieben werden. Mittlerweile wurde auch damit begonnen, miniaturisierte Elektronenstrahlsäulen zu bauen. Verschiedene Forschungsgruppen beschäftigen sich auch damit, Elektronenquellen aus Kohlenstoff-Nanoröhren und anderen Emittern, wie z.B. dotierte Siliziumspitzen mit transistorgesteuertem Emissionsstrom aufzubauen, die auf einem Halbleiterchip in einer Prozessschrittfolge hergestellt werden.

Nachteilig an den vorgenannten Verfahren ist jedoch, dass die Erzeugung einer Vielzahl von miniaturisierten Korpuskularstrahlsystemen sehr lange dauert, d.h. eine sehr lange Produktionszeit benötigt, da jedes System einzeln sukzessive aufgebaut bzw. erzeugt wird. Nachteilig ist auch, dass die Herstellungsprozessschritte der Halbleiterfertigung so großen Toleranzen unterliegen, dass eine gleichartige EmissionsCharakteristik der Feldemitter nicht erreicht wird.

Aus der DE 196 09 234 A1 ist ein gattungsgemäßes Verfahren zur Herstellung von Korpuskularstrahlsystemen sowie eine Vorrichtung zur Herstellung von Korpuskularstrahlsystemen bekannt. Die Vorrichtung besteht dabei aus einer oder mehreren parallel geschalteten Feldemissions- oder Feldionisation-Katoden für Elektroden oder Ionen, einer Gitterelektrode mit einer oder mehreren ringförmigen Öffnungen und einer oder mehreren Anoden. Alle Elektroden werden mit Hilfe der Korpuskularstrahl-Litographie mit indizierter Deposition nacheinander oder gleichzeitig auf einer die Spannungen zuführenden planaren Leiterbahnstruktur aufgebaut. Der Elektrodenabstand wird dabei so klein gewählt, dass im Mittel nur eine mittlere freie Weglänge der Moleküle bei Normaldruck zwischen die Emitter und Anoden-Elektrode passt. Mit der Korpuskularstrahl-indizierten Deposition können leitfähige und isolierende Drähte in der Ebene und im Raum aufgebaut werden. Mit der Deposition, die Rechner gesteuert abläuft, werden also dreidimensionale Strukturen hergestellt, die als Elektrode für Mikro-Röhren und Röhrensysteme dienen, die einzelne Strahlen erzeugen, oder die vielmals nebeneinander hergestellt werden können.

Aufgabe der vorliegenden Erfindung ist es, ein Verfahren zur Herstellung von Korpuskularstrahlsystemen und eine entsprechende Vorrichtung anzugeben, welche den Aufbau einer Vielzahl von miniaturisierten Korpuskularstrahlsystemen in kürzerer Zeit ermöglichen.

Diese Aufgabe wird durch ein Verfahren zur Herstellung von Korpuskularstrahlsystemen mit den Merkmalen nach Anspruch 1 und durch eine entsprechende Vorrichtung mit den Merkmalen nach Anspruch 20 gelöst. Bevorzugte Ausgestaltungen der Erfindung ergeben sich aus den abhängigen Ansprüchen.

Ein wesentlicher Gedanke der Erfindung besteht darin, eine große Anzahl von miniaturisierten Korpuskularstrahlsystemen durch eine Art Selbstreproduktion zu ermöglichen. Dies kann dadurch erreicht werden, dass bereits erzeugte Korpuskularstrahlsysteme zum Erzeugen weiterer Korpuskularstrahlsysteme mittels korpuskularstrahlinduzierter Deposition eingesetzt werden.

Beispielsweise können gemäß der Erfindung mit Hilfe der Elektronenstrahl-induzierten Deposition unter Rechnerführung miniaturisierte Elektronenstrahlsysteme in gro-ßer Zahl hergestellt werden. Als Basis und Grundlage kann hierbei eine durch Lithographie in VLSI-Technik hergestellte Grundschaltung dienen, in welche hinein mit der Elektronenstrahl-induzierten Deposition die Funktionselemente für ein weiteres miniaturisiertes Elektronenstrahlsystem aufgebaut werden. Dieses miniaturisierte System wird dann, nachdem es eine Funktionsprüfung bestanden hat, weiterverwendet, um wiederum in einen ebenfalls vorher vorbereiteten Basis-Chips hinein durch Elektronenstrahl-induzierte Deposition die funktionellen Elemente für ein gleichartiges Elektronenstrahlsystem aufzubauen. Eine wesentliche Eigenschaft des Elektronenstrahlsystems besteht darin, einen feinen Elektronenstrahl auf ein Substrat zu fokussieren und dort durch Zufuhr von organometallischen Verbindungen wiederum Strukturen durch Elektronenstrahl-induzierte Deposition zu erzeugen. Das erfindungsgemäße Verfahren zur Selbstreproduktion von Elektronenstrahlsystemen kann nun in einem ersten Schritt zur Verdoppelung der Anzahl von Elektronenstrahlsystemen den vorher beschriebenen Prozess nutzen, a) um eine Tochtergeneration von Elektronenstrahlsystemen zu erzeugen und b) um die "Tochter"- Elektronenstrahlsysteme zusammen mit dem "Mutter"- Elektronenstrahlsystem parallel einzusetzen, um daraufhin eine zweite Töchtergeneration von nunmehr zwei Elektronenstrahlsystemen parallel aufzubauen. Diese neu aufgebauten Elektronenstrahlsysteme werden dann wieder zu den bereits bestehenden Elektronenstrahlsystemen parallel geschaltet, wodurch vier Elektronenstrahlsysteme erhalten werden, die gemeinsam eingesetzt werden, um in vorbereitete Basis-Chips auf einem Substrat Funktionselemente von weiteren vier Elektronenstrahlsystemen parallel und gleichzeitig aufzubauen, und so fort.

Mit der Erfindung wird die Möglichkeit eröffnet, ein exponentielles Wachstum der Anzahl der Korpuskularstrahlsysteme zu erzielen. Beispielsweise werden nach fünf Generationen 32 funktionsfähige miniaturisierte Korpuskularstrahlsysteme erhalten, die erprobt und funktionsbereit sind. Nach zehn Tochtergenerationen sind bereits 1024 derartige miniaturisierte Systeme und nach 20 Tochtergenerationen 1 Mio. funktionierende Korpuskularstrahlsysteme erhalten worden. Insbesondere schaltet man die derart erzeugten Korpuskularstrahlsysteme in einen Block zusammen und setzt sie als Strahlmatrix mit z.B. bis zu 1 Mio. parallel produktiv wirkenden Korpuskularstrahlen ein, so erhält man mit Vorteil neuartige Produktionsgeräte zur Herstellung von in der Einzelherstellung zu teuren neuen Produkten. Dies wird durch die Tatsache verursacht, dass im Einzelstrahl-Herstellungsverfahren die Produkte eine hohe Herstellungszeit haben und damit hohe Herstellungs-Elektronenstrahl-Maschinenkosten von z.B. mehreren Minuten und damit nur unwirtschaftlich hergestellt werden könnten. Beispiele solcher Produkte sind eine Widerstandsmatrix der Detektorelemente für eine flache Kamera für Multimedia-Anwendungen oder eine Emitter- und Extraktor-Anordnung für die Bildpunkt-Strahlungsquellen für flache Feldemitterelektronenquellen, die in Flachbildschirmen Verwendung finden, und die auch mit Vorteil in einem Hochstrom-Schalter mit niedriger Schaltspannung für die Energieübertragungstechnik Anwendung finden.

Konkret betrifft die Erfindung ein Verfahren zur Herstellung von Korpuskularstrahlsystemen, bei dem auf einem ersten Substrat mindestens ein erstes Korpuskularstrahlsystem mittels korpuskularstrahlinduzierter Deposition und auf mindestens einem zweiten Substrat mindestens ein zweites Korpuskularstrahlsystem von dem mindestens einen ersten Korpuskularstrahlsystem mittels korpuskularstrahlinduzierter Deposition erzeugt wird.

Anschließend kann auf dem ersten Substrat mindestens ein weiteres erstes Korpuskularstrahlsystem von dem mindestens einen zweiten Korpuskularstrahlsystem mittels korpuskularstrahlinduzierter Deposition erzeugt werden.

Vorzugsweise werden abwechselnd erste und zweite Korpuskularstrahlsysteme von den bereits auf den Substraten existierenden zweiten bzw. ersten Korpuskularstrahlsystemen erzeugt.

Insbesondere werden ein erstes und ein zweites Substrat derart zueinander versetzt angeordnet, dass den auf einem Substrat bereits existierenden Korpuskularstrahlsystemen freie Flächen des anderen Substrats gegenüberliegen, so dass die Korpuskularstrahlsysteme des einen Substrats Korpuskularstrahlsysteme auf den freien Flächen des anderen Substrats erzeugen können.

Um die für die Herstellung erforderliche Genauigkeit zu erzielen, werden die Substrate vorzugsweise von einem Rechner gesteuert positioniert.

Eine besonders hohe Positionierungsgenauigkeit ermöglichen Piezoelemente, mit denen insbesondere über einen x-y-z-Verschiebetisch die Substrate zueinander positioniert werden können. Auch mechanische Verschiebetische, die mit Linearmaßstäben in ihrer Bewegung verfolgt werden erfüllen die Präzisionsanforderung für die Platzierung der System-Komponenten.

Jedes Korpuskularstrahlsystem wird vorzugsweise nach seiner Erzeugung elektrisch getestet, um mögliche Defekte bereits während des Herstellungsprozesses zu erkennen.

In einer bevorzugten Ausführungsform des erfindungsgemäßen Verfahrens werden vor der Erzeugung von Korpuskularstrahlsystemen auf den Substraten Schaltungselemente, insbesondere Verdrahtungselemente erzeugt, mit denen die erzeugten Korpuskularstrahlsysteme zumindest teilweise elektrisch verbunden und angesteuert werden.

Insbesondere werden Korpuskularstrahlsysteme auf Anschlusspunkten, die auf einem Substrat vorgesehen sind, erzeugt.

Eine besonders effiziente Herstellung kann dadurch erzielt werden, dass Korpuskularstrahlsysteme auf einem Substrat kammartig nebeneinander angeordnet werden. Insbesondere bestehen wegen der geringen Abmessungen der Systeme Abstände von weniger als 50 µm zwischen den Systemen.

Dabei werden die Zwischenräume zwischen den Systemen mit Vorteil für die elektrostatische Abschirmung der Einzelsysteme gegeneinander mit Hilfe von auf definiertem Gleichspannungs- oder Wechspannungspotential liegenden Elektroden und Leiterbahnen verwendet.

Vorzugsweise führen erste und/oder zweite Korpuskularstrahlsysteme eine Bildauswertung von Bildsignalen durch, die durch Rasterung erzeugt werden, um den Produktionsprozess visuell zu überwachen.

Sowohl Fokussierung, Stigmatisierung und Ablenkung eines Korpuskularstrahls werden vorzugsweise in einem automatischen Ablauf erfolgen und für jedes Korpuskularstrahlsystem kann eine individuelle Fokussierung durchgeführt.

Die Deposition wird in einer bevorzugten Ausführungsform mit ionenstrahlinduzierter Deposition durchgeführt. Alternativ dazu wird die Deposition mit Elektronenstrahlen verwendet.

Vorzugsweise erfolgt die Deposition für das erste herzustellende Korpuskularstrahlsystem mit rastersondenmikroskopischer Deposition mit Niederspannung beispielsweise von etwa 100 V bis etwa 40 kV.

Die Korpuskularstrahlsysteme werden vorzugsweise in Gruppen von einem Steuersystem umfassend eine Steuer- und Programmierelektronik angesteuert und kontrolliert.

Bis zu einer bestimmten Anzahl ist es vorteilhaft, die Korpuskularstrahlsysteme vollständig konfiguriert aufzubauen und dann durch geeignete Zuführung von Gasen zum Aufbau weiterer Korpuskularstrahlsysteme als parallel arbeitende Blöcke von Korpuskularstrahlsystemen einzusetzen.

Insbesondere werden Einzelkämme von Korpuskularstrahlsystemen reproduziert und zu Fertigungssystemen zusammengesetzt.

Die Blöcke können hierbei gemeinsam produziert werden, ohne dass sie weiterhin zusammengesetzt werden müssen.

In einer besonders bevorzugten Ausführungsform sind die Korpuskularstrahlsysteme mit ihren Korpuskularstrahl-Achsen etwa senkrecht zur Oberfläche des Substrats oder der Substrate angeordnet. Insbesondere umfassen die Korpuskularstrahlsysteme eine oder mehrere Feldemitter-Elektronenquelle(n) mit wenigstens einem Extraktor, welcher als Rundlinse oder Quadrupol aufgebaut ist, und einer Fokussierungslinse, welche ebenfalls als Rundlinse oder Quadrupol aufgebaut ist. Die Anordnung aus den Rundlinsen bzw. Quardupolen ermöglicht eine Steuerung des Emissions-Stromes, die Fokussierung und die Ablenkung des Korpuskularstrahles in x-y-Richtung durch eine rechnergesteuerte Einstellung der Versorgungsspannung der Rundlinsen- bzw. Quadrupol-Elektroden.

Insbesondere kann das Rundlinsen- bzw. Quadrupolsystem durch Wahl der Spannungen an den Elektroden den Korpuskularstrahl an- und abschalten. Durch Anlegen der Ablenkspannungen an den Extraktor und die Fokussierlinse wird zudem der Elektronenstrahl zeilenförmig gerastert, im Spiral-Raster oder mit anderen zufälligen oder gezielt gewünschten Koordinaten-Werten oder gezielt von Punkt zu Punkt bewegt.

Vorzugsweise sind um ein Korpuskularstrahlsystem Drähte, die Sekundärelektronen detektieren, und/oder Metall-Flächen angeordnet, welche die von dem Primärstrahl bzw. Korpuskularstrahl auf dem gegenüberliegenden Substrat erzeugten Sekundärelektronen aufnehmen. Die Drähte bzw. Metall-Flächen verstärken die Sekundärelektronen in der Ausführungsform eines offenen Multipliers und führen sie einem Bildsignal-Anzeigegerät synchron zur Ablenkung oder einer Anzeige zu.

Insbesondere werden die Bildsignale und Sekundärsignale der Sekundärelektronen zur Prozeßsteuerung und Bildanzeige verwendet.

Die Strahlen der Korpuskularstrahlsysteme werden vorzugsweise zum Aufbau weiterer Korpuskularstrahlsysteme, Tochtersysteme oder Strahlquellen verwendet, die insbesondere auf einer in einem vorgegebenen Abstand angeordneten, über einen x-y-z-Verschiebetisch positionierbaren vorstrukturierten Halbleiterschaltung hergestellt werden. Die Halbleiterschaltung wird hierbei vorzugsweise durch Vorstrukturierung mit Anschlüssen, Depositions-Fusspunkten und Systemelektronik in Form von Halbleiterschaltungen hergestellt.

Insbesondere ist eine erzeugte neue Tochterstruktur gleichartig zur Vervielfältigung der Mutter-Anordnung ausgeführt.

In einer bevorzugten Ausführungsform ist die Tochterstruktur andersartig, aber ebenfalls korpuskularstrahlspezifisch aufgebaut, um andersartige Korpuskularstrahl-Anwendungen in mehrfacher Form auf den Substraten zu erzeugen und zur Funktion zu bringen, z.B. die vom Erfinder patentierten Mikroröhren für Elektronenverstärker im THz-Bereich, für Schaltungen für Bit-Fehler-Raten Messplätze für die Telekommunikation im oberen GHz Bereich oder für Hochstrom-Elektronenquellen für die schnelle leistungsarme Schaltung von sehr hohen Strömen für die Energieverteilung.

Um die Deposition überall in gleicher Weise zu ermöglichen werden die zur Deposition erforderlichen Gase vorzugsweise zwischen gegenüber angeordneten Substraten mit ausreichend hohem Druck eingebracht.

Um zu verhindern, dass bei der Deposition auf der Tochterebene erzeugte Ionen auf der Mutterebene Deponieren, und umgekehrt, wird bei der Wahl der Spannungen in den Systemen Sorge getragen, dass ein Ionenspiegel-Effekt eintritt, welcher diese Ionen von den empfindlichen Strukturen der Mutter-Ebene repsektive Tochtereebene fern hält und sie durch Verwendung geeigneter Potentiale gezielt auf dafür vorgesehenen geeigneten Stellen sammelt und unschädlich macht. Solche Stellen sind zum Beispiel Linsenelektroden oder vorgefertigte Auffangflächen, die auf gegenüber dem Auftreff-Ort der Primärelektronen negativem Potential liegen.

Die Substrate werden vorzugsweise rechnergesteuert gegeneinander verschoben, so dass ebenfalls auf den Substraten befindliche und durch vorstrukturierende Lithographie und Lithographieverfahren hergestellte Teststrukturen es ermöglichen, erzeugte Tochterstrukturen oder Spezialstrukturen in ihrer Eigenschaft zu vermessen und zu kalibrieren.

Durch Verdoppelung der getesteten und gegebenenfalls durch Reparatur wieder funktionsfähig gemachten Strukturen werden diese in exponentiell wachsenden Zahlen erzeugt.

Die vielfach erzeugten Korpuskularstrahlsysteme werden vorzugsweise zur ökonomischen Herstellung von einzelnen, von in Gruppen durch Aufteilung der Flächen oder von flächigen Anordnungen derartiger Systeme eingesetzt.

Gemäß einem weiteren Aspekt betrifft die Erfindung eine Vorrichtung zur Herstellung von Korpuskularstrahlsystemen mit einem ersten Substrat und mindestens einem zweiten Substrat, wobei sich auf dem ersten Substrat mindestens ein mittels korpuskularstrahlinduzierter Deposition erzeugtes erstes Korpuskularstrahlsystem befindet.

Insbesondere sind das erste und das mindestens zweite Substrat derart zueinander versetzt angeordnet, dass den auf einem Substrat bereits existierenden Korpuskularstrahlsystemen freie Flächen des anderen Substrats gegenüberliegen, so dass die Korpuskularstrahlsysteme des einen Substrats Korpuskularstrahlsysteme auf den freien Flächen des anderen Substrats erzeugen können.

In einer bevorzugten Ausführungsform zeichnet sich die Vorrichtung durch einen Rechner aus, der programmtechnisch eingerichtet ist, um die Anordnung der Substrate insbesondere über einen Verschiebetisch in x-y-z-Richtung zu steuern.

Ferner werden vorteilhafterweise Piezoelemente an den Substraten vorgesehen, um diese zueinander mit hoher Präzision elektrisch gesteuert und vermessen zu positionieren.

Während der Herstellung wird vorzugsweise die Funktionsfähigkeit der Korpuskularstrahlsysteme überprüft durch vorgesehene Testmittel, wie Bildwiedergabe, elektrische Strom- und Spannungsdetektion und Anzeige, und andere Anzeigen, die zum Testen jedes Korpuskularstrahlsystems auf den Substraten ausgebildet und elektrisch angeschlossen sind.

In einer besonders bevorzugten Ausführungsform ist das erste und zweite Substrat ein Halbleiter, insbesondere Silizium. In diesem Fall werden mittels Halbleiterherstellungsverfahren, wie diese auch zur Produktion von integrierten Schaltungen angewandt werden, elektronische Komponenten auf den Substraten für die Korpuskularstrahlsysteme erzeugt. Falls hohe Spannungen in den Korpuskularstrahlsystemen erforderlich sind, wird mit Vorteil die elektronische Steuer- und Vermessungs-Schaltung auf einem isolierenden Substrat wie Glas oder Keramik mit Halbleitertechnischen Prozessen hergestellt.

Insbesondere wird vorteilhafterweise das Substrat Schaltungselemente, insbesondere Verdrahtungselemente aufweisen, mit denen Korpuskularstrahlsysteme zumindest teilweise elektrisch verbunden werden.

Die Schaltungselemente sind beispielsweise insbesondere rechnergesteuerte Korpuskularstrahlstromregler, Heizstromregler, Korpuskularstrahlablenkverstärker, Blendenablenkverstärker, Rastergenerator, Funktionsgenerator mit Speicher, Linseneinstellmittel, Linsenspannungsverstärker, Bildsignalverstärker, Astigmatismus-Spannungsverstärker und/oder Ablenkungsspannungsverstärker.

Typischerweise weist ein Substrat mindestens eine Fläche mit einer Breite von etwa 2 µm bis etwa 2500 µm und einer Länge von etwa 10 µm bis zu etwa 100 mm für ein Korpuskularstrahlsystem auf.

Ferner weist ein Substrat in einer bevorzugten Ausführungsform Anschlusspunkte für Korpuskularstrahlsysteme auf, beispielsweise metallisierte elektrische Kontaktpunkte zum Anschliessen von Komponenten der Korpuskularstrahlsysteme.

Vorzugsweise sind Korpuskularstrahlsysteme auf einem Substrat kammartig nebeneinander angeordnet, was produktionstechnisch besonders vorteilhaft ist, da sich die Substrate Seite an Seite anordnen lassen und alle Korpuskularstrahlsysteme eines Substrats dann zur Erzeugung von Korpuskularstrahlsystemen auf dem gegenüberliegenden ebenfalls kammartigen Substrat gleichzeitig arbeitend eingesetzt werden. Die kammartige Anordnung unterstützt mit Vorteil die Verbindungstechnik unter Verwendung von industriell eingesetzten Platinenstecker-Buchsen zum Prüfen und Betreiben der gefertigten Elemente

In einer bevorzugten Ausführungsform sind mindestens ein erstes und mindestens ein zweites Korpuskularstrahlsystem mit Mess- und Stabilisatorschaltungen versehen, die zum Messen und Stabilisieren von Korpuskularstrahlung dienen.

Es werden ferner in einer bevorzugten Ausführungsform Schaltungselemente vorgesehen, welche die Korpuskularstrahlsysteme mit Spannung und Strom versorgen und es ermöglichen, diese mittels Speicher programmierbar einzustellen. Dies ermöglicht den Aufbau sehr flexibler, da programmierbarer Korpuskularstrahlsysteme.

Vorzugsweise sind die Korpuskularstrahlsysteme mit Mitteln versehen, die zum Ausführen eines automatisierten Prüfverfahrens ausgebildet sind, welches die Funktionsfähigkeit und Stabilität der Strahlung und der Bildaufnahme und Bildauswertung gewährleistet.

Die Korpuskularstrahlsysteme werden vorteilhafterweise mit bildanzeigenden Mitteln verbunden, die in einem Bildschirm oder Großbildschirm mit entsprechender Bildaufteilung für die einzelnen Korpuskularstrahlsysteme bestehen, so dass die Arbeit des Systems überwacht und sein Ergebnis für anderweitige Weiterverwendung zur Verfügung gestellt wird.

Die bildanzeigenden Mittel weisen insbesondere dateninformationsreduzierende Routinen auf, um die Überwachung zu unterstützen und um zu gewährleisten, dass im Wesentlichen nur Fehler gespeichert werden müssen.

Vorzugsweise weisen die Korpuskularstrahlsysteme Elektronenquellen oder Gas- oder Flüssigkeitsionenquellen auf.

Schließlich betrifft die Erfindung die Verwendung des erfindungsgemäßen Verfahrens und/oder der erfindungsgemäßen Vorrichtung zur Herstellung von ebenen verteilten Bauelementen, insbesondere einer Widerstandsmatrix für eine flache Kamera, eines Flachbildschirms mit Korpuskularstrahlquellen, von Linsenarrays und einer Schreib-/Leseanordnung für einen Speicher, sowie andere bereits oben genannte Anwendungen.

Weitere Vorteile und Anwendungsmöglichkeiten der vorliegenden Erfindung ergeben sich aus der nachfolgenden Beschreibung in Verbindung mit den in der Zeichnung dargestellten Ausführungsbeispielen.

In der Beschreibung, in den Ansprüchen, der Zusammenfassung und in den Zeichnungen werden die in der hinten angeführten Liste der Bezugszeichen verwendeten Begriffe und zugeordneten Bezugszeichen verwendet.

In den Zeichnungen bedeutet:
- Fig. 1: eine schematische Darstellung einer erfindungsgemäßen sukzessiven Herstellung von miniaturisierten Elektronenstrahlsystemen mit Hilfe vorgefertigter Schaltkreise und Elektronenstrahl-induzierter Deposition zum Aufbau funktionaler Gruppen von Korpuskularstrahlsystemen,
- Fig. 2: eine schematische Darstellung eines einzelnen Elektronenstrahlsystems, das auf einer vorgegebenen Fläche auf einem Substrat durch Elektronenstrahl-induzierte Deposition gemäß der Erfindung aufgebaut wurde,
- Fig. 3: eine Seitenansicht eines Elektronenstrahlsystems, dessen Strahlachse senkrecht zum Substrat angeordnet ist,
- Fig. 4: eine perspektivische Ansicht des in Fig.3 dargestellten Elektronenstrahlsystems,
- Fig. 5: die verschiedenen Potentiale im Elektronenstrahl, der von dem in den Fig. 3 und 4 dargestellten Elektronenstrahlsystem emittiert wird,
- Fig. 6: eine Draufsicht auf das in Fig. 3 dargestellte Elektronenstrahlsystem,
- Fig. 7: ein Gitter zur Ablenkkalibrierung und daneben ein mittels Elektronenstrahl-Deposition erzeugter Zylinderaufbau zur Bildung eines Faraday-Käfigs zur Strommessung, und
- Fig. 8: eine Detailansicht des in Fig. 7 dargestellten Gitters mit den in Fig. 7 dragestellten Zylinderaufbauten.

Im folgenden können gleiche und funktional gleiche Elemente mit denselben Bezugszeichen versehen sein.

Eine Besonderheit des erfindungsgemäßen Verfahrens ist durch den Einsatz einer rechnergesteuerten Elektronenstrahl-induzierten Deposition gekennzeichnet. So kann beispielsweise in ca. 20-30 Min. auf einem vorbereiteten ersten Basis-Chip als erstes Substrat, der Stabilisierungs-, Steuer-, Auswertungs- und andere Schaltkreise aufweist, ein miniaturisiertes Elektronenstrahlsystem hergestellt werden. Die hierfür eingesetzte Herstellungstechnik ist eine Reparaturtechnik, welche die Korrektur und Fehlerbehebung in den deponierten Strukturen ermöglicht. Mit dieser Technik wird ein erstes Elektronenstrahlsystem aufgebaut und danach durch Anlegen von erforderlichen Versorgungsspannungen eingeschaltet. Nach dem Einschalten erfolgt ein elektronischer Test des erzeugten Systems.

Die durch Deposition gefertigten Elemente des ersten Elektronenstrahlsystems wie elektrostatische Linsen und ein Abbildungssystem, das mit einer Strahlablenkung und mit oder ohne einer Aperturblende ausgerüstet ist, ermöglichen eine Fokussierung mit hoher Strahlstromdichte in einem geringen Arbeitsabstand. Dadurch wird es ermöglicht, durch eine Elektronenstrahl-induzierte Deposition weitere Bauelemente von Elektronenstrahlsystemen auf einem zweiten Basis-Chip als zweites Substrat abzuscheiden.

Um ein zweites Elektronenstrahlsystem aufzubauen, wird der zweite Basis-Chip durch mechanische Plazierung bzw. Anordnung gegenüber dem ersten Basis-Chip mit nm-Präzision ausgerichtet. Durch bildverarbeitende Mittel werden dann im Mix- und Match-Verfahren die Elektroden des zweiten Elektronenstrahlsystems auf Nanometer genau plaziert auf dem zweiten Basis-Chip hergestellt. So wird ein eine Quelle, einen Kondensor, eventuell eine Blende, ein Ablenksystem, eine Ablenklinse und einen Detektor umfassendes zweites Elektronenstrahlsystem erzeugt, das in seiner Gesamtgröße zwischen 1 und 100 µm lang ist.

Dieses miniaturisierte Elektronenstrahlsystem ermöglicht eine Fokussierung eines Elektronenstrahls durch die letzte Linse des Systems mit 20 bis 100 eV in einem Arbeitsabstand von einigen µm. Die Fokussierung kann dabei so fein werden wie bei einem herkömmlichen 20 kV-Elektronenstrahlsystem, da Linsenfehler der elektrostatischen miniaturisierten Linsen aus leitenden Drähten sehr viel kleiner sind, als die der herkömmlichen gro-ßen elektrischen und magnetischen Linsen in einem 20 kV-Elektronenstrahlsystem. Dementsprechend sind die Bildfehler um Größenordnungen kleiner. Ein derartiges miniaturisiertes Elektronenstrahlsystem ermöglicht daher bei ähnlich großer Apertur eine ähnliche Auflösung wie bei einem herkömmlichen etwa 1 m großen Elektronenstrahlsystem.

Die erfindungsgemäße Herstellung vieler miniaturisierter Elektronenstrahlsysteme wird mit Vorteil durch eine roboterartige Führung der Substrate, auf denen die Systeme aufgebaut werden, verbessert. Hierzu gibt es zwei unterschiedliche Verfahren.

Bei einem ersten Verfahren wird ein herkömmliches Raster-Elektronenstrahlsystem verwendet, das mit einer speziellen mehrkanaligen Gaszuführung zur Lieferung von Präkursoren für die Deposition ausgerüstet ist. Das Raster-Elektronenstrahlsystem erzeugt auf einem spezifischen Basis-Chip eines ersten Substrats für ein herzustellendes Elektronenstrahlsystem eine Elektrodenkonfigurationen, eine Elektronenquelle, eventuell eine Blende, eine Ablenklinse und einen Detektor durch Aufwachsen in vorbereitete Anschlusspunkte des spezifischen Basis-Chips. Dieses Elektronenstrahlsystem wird nun verwendet, um auf einem weiteren vorbereiteten Basis-Chip auf gleiche Weise, nämlich durch Depositions-Schreiben senkrecht zum Substrat ein zweites Elektronenstrahlsystem aufzubauen. Beide Chips werden dann parallel angeordnet, mit Spannung versorgt und zu einer Doppelschreibeinheit verbunden. Mit einem derartigen Doppelsystem können zwei weitere Elektronenstrahlsysteme aufgebaut werden. Insgesamt können so 2ⁿ Elektronenstrahlsysteme bei n Systemgenerationen hergestellt werden.

Ein zweites Verfahren besteht darin, auf einem ersten, kammartigen Substrat, das eine Vielzahl von kammartig angeordneten Basis-Chips aufweist, mit einem Raster-Elektronenstrahlsystem ein erstes Elektronenstrahlsystem auf einem der Basis-Chips zu erzeugen. Dem ersten Substrat wird dann ein zweites, ähnlich kammartig ausgebildetes Substrat gegenübergestellt, genauer gesagt in einem Winkel von etwa 90° zum ersten Substrat angeordnet. Das zweite Substrat wird dann mechanisch relativ zum ersten Substrat derart bewegt, dass mittels des ersten Elektronenstrahlsystems auf dem ersten Substrat die Elektronenquelle, die Elektroden und weitere Systemfunktionselemente eines zweiten Elektronenstrahlsystems auf dem zweiten Substrat erzeugt werden.

Wenn dieses zweite "Tochter"-Elektronenstrahlsystem erzeugt ist, wird es ebenfalls wie das erste Elektronenstrahlsystem mit Strom versorgt und dazu benutzt, um auf einem zweiten Basis-Chip des ersten Substrats ein weiteres erstes Elektronenstrahlsystem aufzuschreiben, nachdem das erste Substrat mechanisch relativ zum zweiten Substrat derart angeordnet worden ist, dass dem zweiten "Tochter"-Elektronenstrahlsystem eine freie Fläche bzw. ein Basis-Chip gegenüberliegt.

Danach befinden sich auf dem ersten Substrat zwei parallel angeordnete Elektronenstrahlsysteme, die wiederum zum Erzeugen zweier zweiter Elektronenstrahlsysteme auf dem zweiten Substrat verwendet werden. Hierzu schreiben die beiden parallelen Elektronenstrahlsysteme des ersten Substrats auf das etwa rechtwinklig zum ersten Substrat angeordnete zweite Substrat zwei weitere Systeme, so dass sich auf dem zweiten Substrat insgesamt drei Systeme befinden. Diese drei Elektronenstrahlsysteme werden wiederum dazu verwendet, auf das erste Substrat zusätzliche drei Elektronenstrahlsysteme zu erzeugen, so dass sich insgesamt fünf Systeme auf dem ersten Substrat befinden.

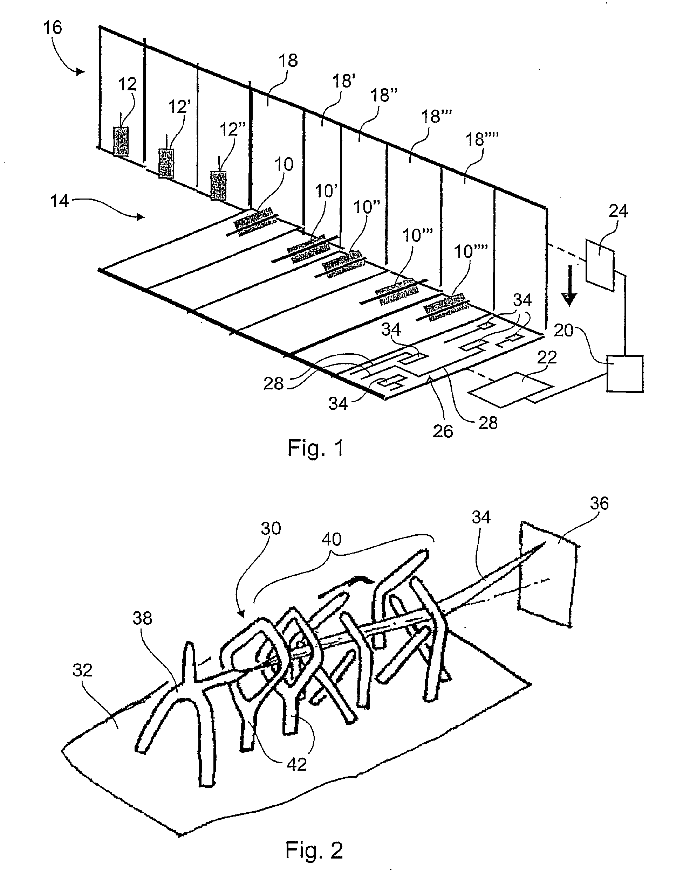

In Fig. 1 sind ein erstes und ein zweites Substrat 14 bzw. 16 dargestellt, auf denen sich erste bzw. zweite miniaturisierte Elektronenstrahlsysteme 10, 10', 10", 10"', 10"" bzw. 12, 12', 12" befinden. Die beiden Substrate 14 und 16 sind kammartig ausgebildet, d.h. sie haben eine etwa rechteckförmige Ausbildung und sind in freie Flächen entsprechend Basis-Chips aufgeteilt, welche für Elektronenstrahlsysteme vorgesehen sind. Die Substrate 14 und 16 sind in einem Winkel von etwa 90° zueinander angeordnet. Ihre Position wird von einem (Steuer-)Rechner 20 kontrolliert, der Piezoelemente 22 und 24 zum exakten Ausrichten der Substrate 14 und 16 ansteuert. Damit ist eine Positionierung der Substrate 14 und 16 möglich, aber mit nm- Genauigkeit.

Die Elektronenstrahlsysteme 10-10"" und 12-12" wurden gemäß dem erfindungsgemäßen Verfahren folgendermaßen erzeugt: zuerst wurde mit einem nicht dargestellten Raster-Elektronenschreiber das erste Elektronenstrahlsystem 10 auf dem ersten Substrat 14 mittels Elektronenstrahl-induzierter Deposition hergestellt. Anschließend wurde das zweite Substrat 16 vom Rechner 20 über das Piezoelement 24 derart zum ersten Substrat 14 ausgerichtet, dass der Basis-Chip für das zweite Elektronenstrahlsystem 12 gegenüber dem ersten Elektronenstrahlsystem 10 angeordnet war. Danach erzeugte das erste Elektronenstrahlsystem 10 das zweite Elektronenstrahlsystem 12. Das zweite Elektronenstrahlsystem 12 wurde nach Fertigstellung in Betrieb genommen und erzeugte nach erfolgreichem Test das erste Elektronenstrahlsystem 10' neben dem Elektronenstrahlsystem 10 auf dem ersten Substrat, nachdem der entsprechende Basis-Chip des ersten Substrats 14 gegenüber dem zweiten Elektronenstrahlsystem 12 plaziert worden war. Die beiden nebeneinander liegenden Elektronenstrahlsysteme 10 und 10' wurden dann zum gleichzeitigen Erzeugen der Elektronenstrahlsysteme 12' und 12" nach entsprechender Positionierung der beiden Substrate 14 und 16 erzeugt. Schließlich deponierten die so erzeugten nebeneinander angeordneten drei Elektronenstrahlsysteme 12-12" die Elektronenstrahlsysteme 10"-10"" gleichzeitig. In einem nächsten Schritt werden dann die Elektronenstrahlsysteme 10-10"" gleichzeitig fünf (nicht dargestellten) Elektronenstrahlsysteme auf dem zweiten Substrat 16 erzeugen. Die beiden Substrate 14 und 16 sind hierfür bereits entsprechend positioniert. Die Basis-Chips bzw. freien Flächen 18-18"" für die zu erzeugenden Elektronenstrahlsysteme auf dem zweiten Substrat sind noch frei.

Eine weitere freie Fläche am rechten Rand des ersten Substrats 14 zeigt schematisch Schaltungselemente 26, die für ein Elektronenstrahlsystem vorgesehen sind. Die Schaltungselemente 26 umfassen Verdrahtungselemente 28, insbesondere Leiterbahnen, und Anschlusspunkte 34, insbesondere freie Metallflächen. Die Anschlusspunkte 34 dienen zum Aufwachsen von Strukturen eines Elektronenstrahlsystems, beispielsweise von Linsen und Blenden. Die Verdrahtungselemente 28 dienen zum elektrischen Verbinden von einem Elektronenstrahlsystem mit weiteren (nicht dargestellten) Schaltungselementen, beispielsweise Strom- oder Spannungsquellen.

In Fig. 2 ist ein vollständiges Elektronenstrahlsystem 30 auf einer Fläche 32 eines Substrats dargestellt, wie es durch das erfindungsgemäße Verfahren auf einem Basis-Chip erzeugt wurde. Der von dem System 30 erzeugte Elektronenstrahl trifft auf ein Objekt 36, das beispielsweise ein weiterer Basis-Chip eines Substrats sein kann, auf dem ein weiteres Elektronenstrahlsystem aufgebaut werden soll. Das Objekt 36 ist etwa in einem Winkel von 90° zum System 30 angeordnet und befindet sich etwa im Brennpunkt des Elektronenstrahls 34.

Das dargestellte Elektronenstrahlsystem 30 umfasst einen Emitter 38 sowie ein Blenden und Linsensystem 40 mit einer Extraktor-Linse aus zwei ringförmigen Elektroden. Eine Blende ist nicht gezeigt. Diese müsste in dem Raum zwischen Extraktorlinse und Ablenklinse angeordnet sein. Wegen der Anordnung der Feldelektronenquelle als Superspitze auf dem Emitterträger kann es ausreiched sein, die auf einen Emissionsort begrenzte Emission ohne zusätzliche Blende vollständig zu verwenden, da dies durch die kleinen Linsenfehler der Extraktorlinse ermöglicht ist, ohne die Quelle in ihrer Größe und Emittanz wesentlich zu verschlechtern. Zudem kann der Fokus des Strahls durch den Rundlinsenateil der Ablenklinse geregelt werden. Ein derartiges Elektronenstrahlsystem 30 wird dazu verwendet, ein "Tochter"- Elektronenstrahlsystem auf dem Objekt 36 mittels Elektronenstrahl-induzierter Deposition gemäß der Erfindung zu erzeugen.

Mit den oben beschriebenen Verfahren entsteht eine spezielle mathematische Reihe von Wachstumszahlen und von Elektronenstrahlsystemen, welche auch ähnlich dem exponentiellen Wachstum zu einer Reproduktion von vielen Elektronenstrahlsystemen führt. Das erfindungsgemäße Verfahren hat den Vorteil, dass zwei funktionsfähige Substrate sukzessive mit Elektronenstrahlsystemen ergänzt aufgefüllt werden, und zum Schluss sehr schnell voll gefüllte Substrate mit Elektronenstrahlsystemen erhalten werden. Um beispielsweise 64 oder 1024 oder gar 1 Mio. von miniaturisierten Elektronenstrahlsystemen zu erhalten, können die Substrate mit ihren parallel arbeitenden Elektronenstrahlsystemen als ganzes eingesetzt werden und neue "Tochter"-Elektronenstrahlsysteme auf einem neuen Substrat gleichzeitig herstellen.

Das zweite Verfahren hat gegenüber dem ersten Verfahren den Vorteil, dass die Substrate mit Elektronenstrahlsystemen nicht in Einzelelemente zerschnitten werden müssen. Ausserdem ist mit Vorteil die Verdrahtung der Versorgungsspannungen und anderer parallel ablaufender elektrischer Steuerungs-Schritte mit in das Substrat bei der Herstellung integriert. Damit wird das Packaging von Einzelkomponenten vermieden und die Zuverlässigkeit der Anordnung wesentlich erhöht.

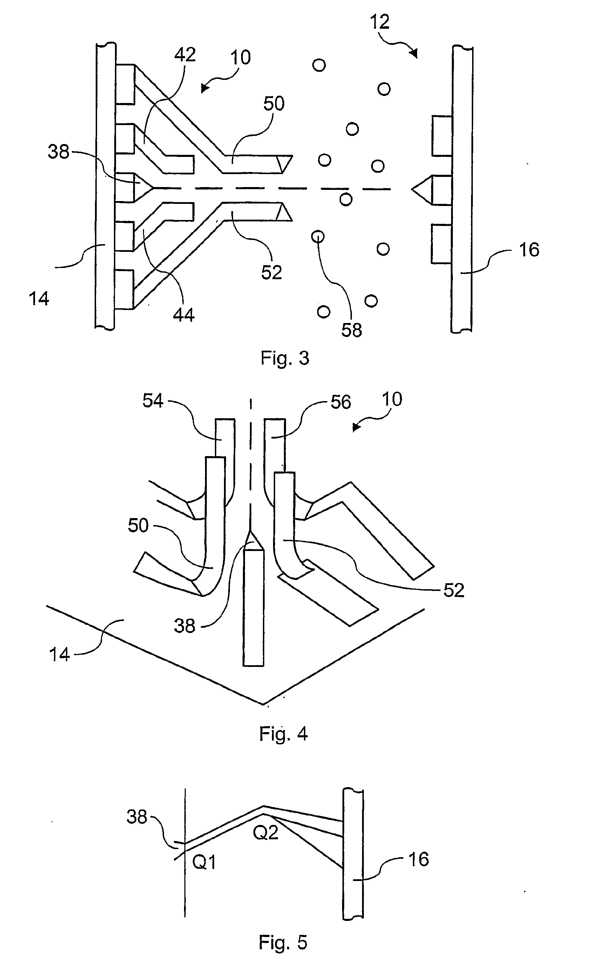

In Fig. 3 ist ein erstes Elektronenstrahlsystem 10 auf einem ersten Substrat 14 in seitlicher Ansicht dargestellt, dessen durch eine gestrichelte Linie angedeuteter Elektronenstrahl etwa senkrecht zum Substrat 14 verläuft. Der Elektronenstrahl des ersten Systems 10 baut auf einem zweiten Substrat 16, das dem ersten Substrat 14 gegenüberliegt, ein zweites Elektronenstrahlsystem 12 mittels Elektronenstrahl-induzierter Deposition auf. Zwischen den beiden plattenförmigen Substraten 14 und 16 befindet sich ein Gas, dessen Gaspartikel 58 für die Deposition erforderlich sind. Das Gas weist einen für die Deposition ausreichend hohen Druck zwischen den Substraten 14 und 16 auf.

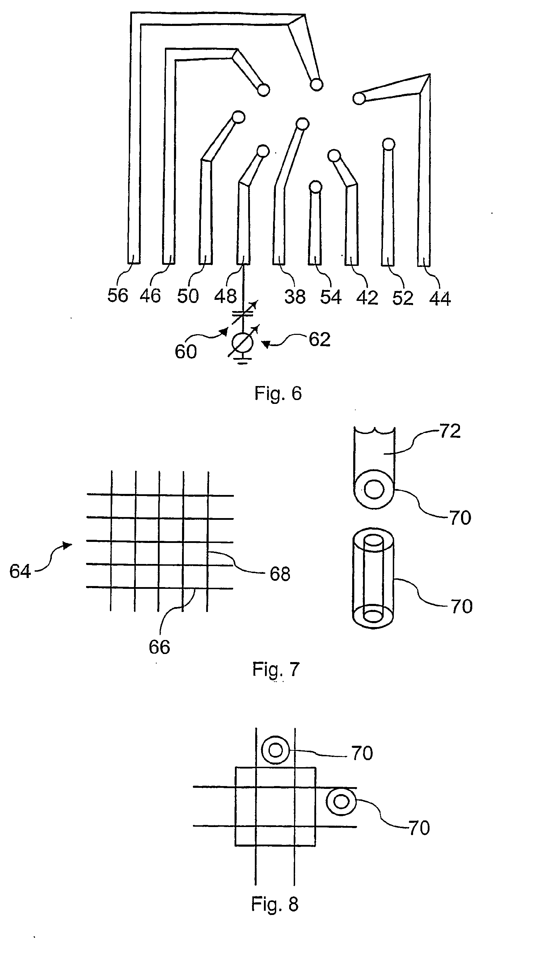

Das erste Elektronenstrahlsystem 10 umfasst eine feine Metallspitze als Emitter 38 für Elektronen. Weiterhin weist das erste System 10 einen ersten Quadrupol mit den Quadrupol-Elektroden 42 und 44 und einen zweiten Quadrupol mit den Quadrupol-Elektroden 50 und 52 auf. Die entsprechend zum Quadrupol gehörigen weiteren zwei Elektroden in der zur Zeichenebene senkrechten Ebene durch die Strahlachse sind nicht gezeichnet, werden aber in den folgenden Figuren 4 im Schrägbild für den ersten Quadrupol und in Figur 6 mit ihren Fußpunkten an den Endpunkten der Anschlussleiterbahnen 42, 44, 46, 48 und 50 - 56 in der Anschlussstruktur dargestellt. Der erste Quadrupol 42, 44, (46, 48 nicht gezeigt) dient als Extraktor, um die vom Emitter 38 emittierten Elektroden zu beschleunigen. Der zweite Quadrupol 50, 52, (54, 56 nicht gezeigt) ist in Richtung vom ersten zum zweiten Substrat 14 bzw. 16 hinter dem ersten Quadrupol 42, 44 angeordnet und dient als Fokussierungslinse für den Elektronenstrahl. Mittels einer rechnergesteuerten Einstellung der Versorgungsspannung der Elektroden der beiden Quadrupole 42, 44, 50, 52 wird der Emissionsstrom des Emitters 38, die Fokussierung und Ablenkung des Elektronenstrahls in x-y-Richtung ermöglicht, wobei die x-y-Ebene etwa parallel zu den Ebenen liegt, in welchen sich die Substrate 14 und 16 befinden. Fig. 4 zeigt das in Fig. 3 dargestellte erste Elektronenstrahlsystem 10 in perspektivischer Ansicht. Neben den Elektroden 50, 52, 54, 56 des zweiten Quadrupols ist der Emitter 38 zu erkennen. Der erste Quadrupol von Fig. 3 ist in dieser Ansicht nicht dargestellt.

Fig. 5 zeigt das Potential eines von einem Emitter 38 emittierten Elektronenstrahls. An der Spitze des Emitters 38 herrscht ein Potential Q1. Wenn der Elektronenstrahl aus dem Elektronenstrahlsystem austritt weist er ein Potential Q2 auf, das im Wesentlichen vom zweiten Quadrupol bestimmt wird. Der Elektronenstrahl trifft auf das zweite Substrat 16 mit einem Bremspotential auf. Diese Verzögerung der Primärelektronen bewirkt eine Beschleunigung der aus dem Substrat ausgelösten Sekundärelektronen und bremst die dort ausgelösten Ionen, so dass sie nicht die Feldemissionskathode erreichen können. In einer weiteren vorteilhaften Ausführung können die Potentialwerte Q1 und Q2 auch vertauscht sein und dennoch das Bremspotential erhalten bleiben.

In Fig. 6 ist das Elektronenstrahlsystem 10 in Draufsicht dargestellt. In dieser Darstellung sind alle Elektroden des Systems zu erkennen. Der erste Quadrupol wird durch die Elektroden 42, 44, 46, 48 und der zweite Quadrupol durch die Elektroden 50, 52, 54, 56 gebildet. Die Ansteuerung der Elektroden ist beispielhaft für die Elektrode 48 dargestellt. Sie umfasst für die Elektrode 48 eine einstellbare Spannungsquelle 60, die über ein Strom-Messgerät 62 mit der Erde verbunden ist. Über die einstellbare Spannungsquelle 62 kann das Potential der Elektrode 48 eingestellt werden. Die Elektroden 50, 52, 54 und 56 werden auch als Fänger für Sekundärelektronen verwendet. Alle Signale der Elektroden 50, 52, 54 und 56 werden mit einem Summierverstärker anstelle dem Einzelnen Strom-Messgerät pro Elektrode, wie bei 48 exemplarisch dargestellt, addiert und zur Bildauswertung verwendet. Damit kann der Aufbau des zweiten Elektronenstrahlsystems 12 auf dem zweiten Substrat 16 visuell überwacht werden, indem ein mit der x-y Ablenkung synchron laufender Schreibstrahl einer Bildwiedergaberöhre in seiner Helligkeit mit dem verstärkten Sekundärelektronensignal moduliert wird.

Fig. 7 zeigt ein Gitter 64 zur Ablenkkalibrierung von Elektronenstrahlen. Dieses Gitter 64 kann auch zur Messung des Astigmatismus durch ein Moiré-Verfahren eingesetzt werden, indem die Elektronensonde unter einem sehr kleinen Winkel zur Gittersteg-Kante geführt wird und aus der Zahl der im Sekundärelektronensignal sichtbaren Querstege auf den benötigten Weg geschlossen wird, um die Sonde ganz auf den Steg zu fahren oder ganz vom Steg zu bewegen. Die Auflösung des Verfahrens ist proportional zu 1 / Winkel zwischen Sondenbewegungsrichtung und Gittersteg. Wie mit dem Gitter eine Messung und Kalibrierung des Astigmatismus erfolgt, ist in der Veröffentlichung "Metrology-Chip for Measurement of Diameter and Astigmatism of an Electron Beam with nm Resolution Using Moire Amplification", H.W.P. Koops, B.Hübner, M.Watanabe, Microelectronic Engineering 23 (1994) S.387-390, genauer beschrieben. Das Gitter 64, das Quer- und Längsstäbe 66 bzw. 68 umfasst, ist auf einem Substrat angeordnet und dient im wesentlichen als Kalibriermuster und Detektorfläche zur Strommessung. Es weist den in Fig. 7 rechts neben dem Gitter 64 dargestellten Zylinder 70 auf. Der Zylinder 70, dessen Höhe sehr viel größer als sein Durchmesser ist, ist mittels Deposition erzeugt worden. Der Zylinder bildet einen Faraday-Käfig zur Strommessung und ist hierzu mit Leiterbahnen 72 des Gitters 64 kontaktiert.

Die in Fig. 8 dargestellte Detailansicht des Gitters 64 zeigt, wie die Zylinder 70 im Gitter angeordnet sind.

Das Wachstum der Vielzahl von Elektronenstrahlsystemen gemäß der Erfindung ermöglicht den Einsatz vieler lokal, separat geführter Elektronenstrahlsysteme für die Fertigung mittels Elektronenstrahl-induzierter Deposition. Durch die Größe dieser miniaturisierten Systeme wird eine Strahldichte im Bereich von etwa 250 µm und darunter als Strahlabstand längs eines kammförmigen Substrats erreicht. Durch Aufeinanderlegen von derartig mit Elektronenstrahlsystemen versehenen Substraten wird ein Abstand der Strahlen senkrecht zum Kamm von wiederum z.B. etwa 250 µm erreicht, bzw. der die Steuerelektronik tragenden Halbleiterdicke. Das entspricht der Dicke eines Silizium-Wafers, aus welchen die Substrate mit Basis-Chips gefertigt wurden. Diese Strahldichte von etwa 250 x 250 µm Abstand in einer Fläche von etwa 30 mm x 30 mm ermöglicht 1440 Strahlen, die zur Herstellung von eben verteilten Bauelementen, die mit einem derartigen Rastermaß gebraucht werden, eingesetzt werden.

Beispielsweise kann die Rastermatrix zur Herstellung einer Widerstandsmatrix für eine flache Kamera mit Elektronenstrahl-induzierter Deposition eingesetzt und diese in Massenproduktion hergestellt werden. Eine weitere vorteilhafte Anwendung derartiger Parallelstrahl-Systeme dient der Herstellung von Flachbildschirmen mit Elektronenquellen. Die Elektronenquellen bestehen hierbei je aus Emitter und Extraktor. Damit müssen nur zwei Drahtelektroden hergestellt werden, von welchen eine eine feine Spitze hat. Dies gilt auch für die Herstellung von Linsenarrays durch Elektronenstrahlbelichtung und anderen eben in einem Rastermaß geforderten Depositions- und Belichtungsstrukturen. Zum weiteren können derartige Systeme, da sie eigenständige Detektoren beinhalten, auch zum Vermessen von Strukturen in paralleler Anordnung der Elektronenstrahlen verwendet werden. Auf diese Weise kann der Durchsatz der Elektronenstrahlmesstechnik in der Halbleiterfertigung mit hoher Auflösung vervielfacht werden.

Zudem ist das Schreiben von Elektronenstrahllithographiestrukturen mit viel höherer Schreibgeschwindigkeit mit einem mit dem erfindungsgemäßen Verfahren hergestellten Elektronenstrahlsystem-Array möglich, da verhindert wird, dass der Gesamtelektronenstrom durch eine Optik fließt. Bei den im Raster angeordneten Elektronenstrahlsystemen fließt dagegen der Elektronenstrahlstrom durch 2ⁿ Optiken (wenn n Generationen von Elektronenstrahlsystemen mit dem erfindungsgemäßen Verfahren gemäß dem oben beschrieben ersten oder zweiten Verfahren hergestellt wurden). Dadurch kann man die Schreibzeit t auf t/2ⁿ verringern, was für die Großflächenlithographie insbesondere für Nanostrukturen von großem Vorteil ist, beispielsweise beim direkten Schreiben von Masken oder Wafer-Belichtungen für die Produktion von integrierten Schaltungen.

Eine weitere vorteilhafte Anwendung der Vielzahl von Elektronenstrahlsystemen liegt in der Speichertechnik. Dazu werden Elektronenstrahlsysteme so aufgebaut, daß sie durch Ablenkung ihres Elektronenstrahls in einem Rasterfeld von beispielsweise etwa 100 µm x 100 µm die Speicherelemente, zum Beispiel elektrische oder magnetische Speicherzellen-Elemente von etwa 30 nm Durchmesser herstellen und auch ansprechen können. Durch geeignete Auswertung der Strahl-Antwort in Form von rückgestreuten oder gespiegelten Elektronen kann der Speicherzelleninhalt gelesen und eine Speicherung der Information ohne die Verwendung beweglicher Teile ermöglicht werden. In der Fläche von etwa 100 µm x 100 µm können sich beispielsweise 9 Millionen Speicherzellen befinden. Mit z.B. 1000 parallel arbeitenden Elektronenstrahlsystemen, die mit dem erfindungsgemäßen Verfahren hergestellt wurden, wären 9 Gbit ansprechbar. Zudem kann durch die Verwendung von parallel arbeitenden Schreib- und Lesestrahlen die Datenübertragungsrate gegenüber herkömmlichen Speichersystemen wie beispielsweise DRAM-Chips oder auch Festplatten erhöht werden. Gleichzeitig wird der Einsatz mechanisch bewegter Teile vermieden, was die Zuverlässigkeit der Anordnung erhöht.

### BEZUGSZEICHENLISTE

- 10-10"": erste Elektronenstrahlsystem
- 12-12": zweite Elektronenstrahlsysteme
- 14: erstes Substrat
- 16: zweites Substrat
- 18-18"": freie Flächen
- 20: Rechner
- 22, 24: Piezoelemente
- 26: Schaltungselemente
- 28: Verdrahtungselemente
- 30: Elektronenstrahlsystem
- 32: Fläche
- 34: Anschlusspunkte
- 36: Objekt
- 38: Emitter
- 40: Linsensystem
- 42: Extraktor-Linse in Figur 2
- 42: Elektrode des ersten Quadrupols (Extraktor-Linse)
- 44: Elektrode des ersten Quadrupols (Extraktor-Linse)
- 46: Elektrode des ersten Quadrupols (Extraktor-Linse)
- 48: Elektrode des ersten Quadrupols (Extraktor-Linse)
- 50: Elektrode des zweiten Qüadrupols (Fokusier- und Ablenk-Linse)
- 52: Elektrode des zweiten Quadrupols (Fokusier- und Ablenk-Linse)
- 54: Elektrode des zweiten Quadrupols (Fokusier- und Ablenk-Linse)
- 56: Elektrode des zweiten Quadrupols (Fokusier- und Ablenk-Linse)
- 58: Gaspartikel
- 60: einstellbare Spannungsquelle
- 62: Strom-Messgerät
- 64: Gitter
- 66: Querstäbe
- 68: Längsstäbe
- 70: Zylinder (Faraday-Käfig)
- 72: Leiterbahn

## Patentansprüche

1. Verfahren zur Herstellung von Korpuskularstrahlsystemen (10-10'''', 12-12''), bei dem auf einem ersten Substrat (14) mindestens ein erstes Korpuskularstrahlsystem (10) mittels korpuskularstrahlinduzierter Deposition **dadurch gekennzeichnet, dass** auf mindestens einem zweiten Substrat (16) mindestens ein zweites Korpuskularstrahlsystem (12) von dem mindestens einen ersten Korpuskularstrahlsystem (10) mittels rechnergeführter korpuskularstrahlinduzierter Deposition erzeugt wird, anschliessend auf dem ersten Substrat (14) mindestens ein weiteres erstes Korpuskularstrahlsystem (10') von dem mindestens einen zweiten Korpuskularstrahlsystem (12) mittels rechnergeführter korpuskularstrahlinduzierter Deposition erzeugt wird.

2. Verfahren nach Anspruch 1, **dadurch gekennzeichnet, dass** abwechselnd erste und zweite Korpuskularstrahlsysteme (12', 12 ", 10", 10"', 10"") von den bereits auf den Substraten (14, 16) existierenden zweiten bzw. ersten Korpuskularstrahlsystemen erzeugt werden.

3. Verfahren nach einem der Ansprüche 1 oder 2, **dadurch gekennzeichnet, dass** das erste und das zweite Substrat (14, 16) derart zueinander versetzt angeordnet werden, dass den auf einem Substrat (14) bereits existierenden Korpuskularstrahlsystemen (10-10"") freie Flächen (18-18"") des anderen Substrats (16) gegenüberliegen, so dass die Korpuskularstrahlsysteme (10-10"") des einen Substrats (14) Korpuskularstrahlsysteme auf den freien Flächen (18-18''''') des anderen Substrats (16) erzeugen können.

4. Verfahren nach Anspruch 3, **dadurch gekennzeichnet, dass** die Substrate (14, 16) von einem Rechner (20) gesteuert positioniert werden.

5. Verfahren nach Anspruch 3 oder 4, **dadurch gekennzeichnet, dass** die Substrate (14, 16) mittels Piezoelementen (22, 24) zueinander positioniert werden.

6. Verfahren nach einem der vorangehenden Ansprüche, **dadurch gekennzeichnet, dass** jedes Korpuskularstrahlsystem (10-10"", 12-12'') nach seiner Erzeugung elektrisch getestet wird.

7. Verfahren nach einem der vorangehenden Ansprüche, **dadurch gekennzeichnet, dass** vor der Erzeugung von Korpuskularstrahlsystemen auf den Substraten Schaltungselemente (26), insbesondere Verdrahtungselemente (28) erzeugt werden, mit denen Korpuskularstrahlsysteme zumindest teilweise elektrisch verbunden werden.

8. Verfahren nach einem der vorangehenden Ansprüche, **dadurch gekennzeichnet, dass** Korpuskularstrahlsysteme auf Anschlusspunkten (34), die auf einem Substrat (14) vorgesehen sind, erzeugt werden.

9. Verfahren nach einem der vorangehenden Ansprüche, **dadurch gekennzeichnet, dass** Korpuskularstrahlsysteme auf einem Substrat kammartig nebeneinander angeordnet werden.

10. Verfahren nach einem der vorangehenden Ansprüche, **dadurch gekennzeichnet, dass** erste und/oder zweite Korpuskularstrahlsysteme eine Bildauswertung von Bildsignalen, die durch Rasterung erzeugt werden, durchführen.

11. Verfahren nach einem der vorangehenden Ansprüche, **dadurch gekennzeichnet, dass** sowohl Fokussierung, Stigmatisierung und Ablenkung eines Korpuskularstrahls in einem automatischen Ablauf erfolgen und für jedes Korpuskularstrahlsystem eine individuelle Fokussierung durchgeführt wird.

12. Verfahren nach einem der vorangehenden Ansprüche, **dadurch gekennzeichnet, dass** die Deposition mit rechnergeführter Ionenstrahl-induzierter oder Elektronenstrahl-induzierter Deposition durchgeführt wird.

13. Verfahren nach einem der vorangehenden Ansprüche, **dadurch gekennzeichnet, dass** die Deposition für das erste herzustellende Korpuskularstrahlsystem mit rechnergeführter rastersondenmikroskopischer Deposition mit Niederspannung von etwa 100 V bis etwa 40 kV erfolgt.

14. Verfahren nach einem der vorangehenden Ansprüche, **dadurch gekennzeichnet, dass** die Korpuskularstrahlsysteme in Gruppen von einem Steuersystem umfassend eine Steuer- und Programmierelektronik angesteuert und kontrolliert werden.

15. Verfahren nach einem der vorangehenden Ansprüche, **dadurch gekennzeichnet, dass** die Korpuskularstrahlsysteme bis zu einer bestimmten Anzahl vollständig konfiguriert aufgebaut und dann durch geeignete Zuführung von Gasen zum Aufbau weiterer Korpuskularstrahlsysteme als parallel arbeitende Blöcke von Korpuskularstrahlsystemen verwendet werden.

16. Verfahren nach Anspruch 15, **dadurch gekennzeichnet, dass** Einzelkämme von Korpuskularstrahlsystemen reproduziert und zu Fertigungssystemen zusammengesetzt und konfiguriert werden.

17. Verfahren nach Anspruch 15 oder 16, **dadurch gekennzeichnet, dass** die Blöcke gemeinsam produziert werden, ohne dass sie weiterhin zusammengesetzt werden müssen.

18. Verfahren nach einem der vorangehenden Ansprüche, **dadurch gekennzeichnet, dass** die Korpuskularstrahlsysteme (siehe Figuren 3 bis 6) mit ihren Strahlachsen etwa senkrecht zur Oberfläche des Substrats angeordnet sind.

19. Vorrichtung zur Herstellung von Korpuskularstrahlsystemen (10-10"", 12-12"), mit einem ersten Substrat (14), wobei sich auf dem ersten Substrat (14) mindestens ein mittels rechnergeführter Korpuskularstrahl-induzierter Deposition erzeugtes erstes Korpuskularstrahlsystem (10-10"") befindet, **dadurch gekennzeichnet, dass** mindestens ein zweites Substrat vorgesehen ist, das erste und das mindestens zweite Substrat (14, 16) derart zueinander versetzt angeordnet sind, dass den auf einem Substrat (14) bereits existierenden Korpuskularstrahlsystemen (10-10"") freie Flächen (18-18"") des anderen Substrats (16) gegenüberliegen, so dass die Korpuskularstrahlsysteme (10-10"") des einen Substrats (14) Korpuskularstrahlsysteme auf den freien Flächen (18-18"") des anderen Substrats (16) erzeugen können.

20. Vorrichtung nach Anspruch 19, **gekennzeichnet durch** einen Rechner (20), der programmtechnisch eingerichtet ist, um die Anordnung der Substrate (14, 16) zu steuern.

21. Vorrichtung nach Anspruch 20, **gekennzeichnet durch** Piezoelemente (22, 24) an den Substraten (14, 16), um diese rechnergeführt und nach Bildauswertung der Abbildung der freien Fußpunkte zueinander zu positionieren.

22. Vorrichtung nach einem der Ansprüche 19 bis 21, **gekennzeichnet durch** Testmittel, wie Bildwiedergabe, elektrische Strom- und Sekundärelektronendetektion und Anzeige, und andere Anzeigen, die zum Testen jedes Korpuskularstrahlsystems (10-10'''', 12-12'') auf den Substraten (14, 16) ausgebildet sind.

23. Vorrichtung nach einem der Ansprüche 19 bis 22, **dadurch gekennzeichnet, dass** das erste und zweite Substrat (14, 16) ein Halbleiter, insbesondere Silizium ist.

24. Vorrichtung nach einem der Ansprüche 19 bis 22, **dadurch gekennzeichnet, dass** das erste und zweite Substrat (14, 16) ein Nichtleiter, insbesondere Glas, Keramik oder Quartz ist.

25. Vorrichtung nach einem der Ansprüche 19 bis 24, **dadurch gekennzeichnet, dass** das Substrat Schaltungselemente (26), insbesondere Verdrahtungselemente (28) aufweist, mit denen Korpuskularstrahlsysteme zumindest teilweise elektrisch verbunden sind.

26. Vorrichtung nach Anspruch 25, **dadurch gekennzeichnet, dass** die Schaltungselemente insbesondere rechnergesteuerte Korpuskularstrahlstromregler, Heizstromregler, Korpuskularstrahlablenkverstärker, Blendenablenkverstärker, Rastergenerator, Funktionsgenerator mit Speicher, Linseneinstellmittel, Linsenspannungsverstärker, Bildsignalverstärker, Astigmatismus-Spannungsverstärker und/oder Ablenkungsspannungsverstärker umfassen.

27. Vorrichtung nach Anspruch 25 oder 26, **dadurch gekennzeichnet, dass** die Schaltungselemente insbesondere Rechner-Bausteien wie Zentraleinheit, Rechen-Speicher, Puffer-Speicher, Datenspeicher, und in Hardwaregespeicherte Routinen ausführende Schaltungen sind, die zur Reproduktion der Systeme, der Bilderfassung und Auswertung und zur Herstellung spezieller neuartiger Systeme benötigt werden und diese ermöglichen.

28. Vorrichtung nach Anspruch 27, **dadurch gekennzeichnet, dass** die Schaltungselemente die zur Reproduktion der Systeme, der Bilderfassung und Auswertung und zur Herstellung spezieller neuartiger Systeme benötigt werden und diese ermöglichen im Multiplex-verfahren auf die einzelnen fertigenden Korpuskularstrahlsysteme zu deren Steuerung sequentiell aufgeschaltet werden können.

29. Vorrichtung nach einem der Ansprüche 19 bis 28, **dadurch gekennzeichnet, dass** ein Substrat mindestens eine Fläche (32) mit einer Breite von etwa 2 µm bis etwa 2500 µm und einer Länge von etwa 10 µm bis zu etwa 100 mm für ein Korpuskularstrahlsystem (30) aufweist.

30. Vorrichtung nach einem der Ansprüche 19 bis 29, **dadurch gekennzeichnet, dass** ein Substrat (14) Anschlusspunkte (34) für Korpuskularstrahlsysteme aufweist.

31. Vorrichtung nach einem der Ansprüche 19 bis 30, **dadurch gekennzeichnet, dass** Korpuskularstrahlsysteme auf einem Substrat kammartig nebeneinander angeordnet sind.

32. Vorrichtung nach einem der Ansprüche 19 bis 31, **dadurch gekennzeichnet, dass** mindestens ein erstes und mindestens ein zweites Korpuskularstrahlsystem mit Mess- und Stabilisatorschaltungen versehen sind, die zum Messen und Stabilisieren von Korpuskularstrahlung dienen.

33. Vorrichtung nach einem der Ansprüche 19 bis 32, **dadurch gekennzeichnet, dass** Schaltungselemente vorgesehen sind, welche die Korpuskularstrahlsysteme mit Spannung und Strom versorgen und mittels Speicher programmierbar und einstellbar sind.

34. Vorrichtung nach einem der Ansprüche 19 bis 33, **dadurch gekennzeichnet, dass** die Korpuskularstrahlsysteme mit Mitteln versehen sind, die zum Ausführen eines automatisierten Prüfverfahrens ausgebildet sind, welches die Funktionsfähigkeit und Stabilität der Strahlung und der Bildaufnahme und Bildauswertung gewährleistet.

35. Vorrichtung nach einem der Ansprüche 19 bis 34, **dadurch gekennzeichnet, dass** die Korpuskularstrahlsysteme mit bildanzeigenden Mitteln verbunden sind, wie einem Bildschirm oder Großbildschirm mit entsprechender Bildaufteilung für die einzelnen Korpuskularstrahlsysteme, so dass die Arbeit des Systems überwacht und sein Ergebnis für anderweitige Weiterverwendung zur Verfügung gestellt werden kann.

36. Vorrichtung nach Anspruch 35, **dadurch gekennzeichnet, dass** die bildanzeigenden Mittel dateninformationsreduzierende Routinen aufweisen, um die Überwachung zu unterstützen, und die gewährleisten, dass im Wesentlichen nur Fehler gespeichert werden müssen.

37. Vorrichtung nach einem der Ansprüche 19 bis 36, **dadurch gekennzeichnet, dass** die Korpuskularstrahlsysteme Elektronenquellen oder Gas- oder Flüssigkeitsionenquellen aufweisen.

38. Verwendung eines Verfahren nach einem der Ansprüche 1 bis 18 und/oder einer Vorrichtung nach einem der Ansprüche 19 bis 37 zur Herstellung von ebenen verteilten Bauelementen, insbesondere einer Widerstandsmatrix für eine flache Kamera, eines Flachbildschirms mit Korpuskularstrahlquellen, von Linsenarrays, von Hochstrom-Emitter-Arrays mit niedriger Schaltspannung zur Steuerung des Stromes, von mikro-Elektronenröhren aller Arten und einer Schreib-/Leseanordnung für einen Speicher.

## Claims

1. Process for the production of particle beam systems (10-10'''', 12-12'') in which at least one first particle beam system (10) is formed on a first substrate (14) by particle beam-induced deposition, **characterised in that** at least one second particle beam system (12) is produced on at least one second substrate (16) by the at least one first particle beam system (10) using computer-guided, particle beam-induced deposition, after which at least one second particle beam system (12) is used to produce at least one additional first particle beam system (10') on the first substrate (14) by computer-guided particle beam-induced deposition.

2. Process according to claim 1, **characterised in that** first and second particle beam systems (12', 12", 10", 10"', 10'''') are produced in alternation by the second and first particle beam systems respectively already existing on the substrates (14, 16).

3. Process according to claim 1 or 2, **characterised in that** the first and the second substrates (14, 16) are offset from each other in such a way that free surfaces (18-18'''') of one substrate (16) are opposite the particle beam systems (10-10'''') already existing on the other substrate (14), so that the particle beam systems (10-10'''') of the one substrate (14) can produce particle beam systems on the free surfaces (18-18'''') of the other substrate (16).

4. Process according to claim 3, **characterised in that** the substrates (14, 16) are positioned under the control of a computer (20).

5. Process according to claim 3, **characterised in that** said substrates (14, 16) are positioned with respect to each other by piezoelectric elements (22, 24).

6. Process according to one of the preceding claims, **characterised in that** each particle beam system (10-10"", 12-12") is electrically tested after its production.

7. Process according to one of the preceding claims **characterised in that** before particle beam systems are produced on the substrates, circuit elements (26), especially wiring elements (28), are produced, by means of which at least some of the particle beam systems are electrically connected.

8. Process according to one of the preceding claims, **characterised in that** particle beam systems are produced on contact points (34) provided on a substrate (14).

9. Process according to one of the preceding claims, **characterised in that** particle beam systems are arranged next to each other on a substrate similarly to the teeth of a comb.

10. Process according to one of the preceding claims, **characterised in that** first and/or second particle beam systems evaluate image signals produced by scanning.

11. Process according to one of the preceding claims, **characterised in that** the focusing, stigmation, and deflection of the particle beam are carried out in an automatic sequence, and **in that** each particle beam system is individually focused.

12. Process according to one of the preceding claims, **characterised in that** the deposition is carried out by computer-guided ion beam-induced or electron beam-induced deposition.

13. Process according to one of the preceding claims, **characterised in that** the deposition of the first particle beam system to be produced is carried out by deposition with a computer-guided microscopic scanning probe at low voltages of approximately 100 V to approximately 40 kV.

14. Process according to one of the preceding claims, **characterised in that** the particle beam systems are driven and controlled in groups by a control system comprising electronic control and programming circuitry.

15. Process according to one of the preceding claims, **characterised in that** the particle beam systems are produced and completely configured up to a certain number of particle beam systems, after which these particle beam systems, which are arranged in blocks, are suitably supplied with gases and work in parallel to produce additional particle beam systems.

16. Process according to claim 15, **characterised in that** individual comb-like arrays of particle beam systems are reproduced, assembled into fabrication systems and configured.

17. Process according to claim 15 or 16, **characterised in that** the blocks are all produced together, without the need for further assembly.

18. Process according to one of the preceding claims, **characterised in that** the beam axes of the particle beam systems (see Figures 3-6) are disposed more or less perpendicular to the surface of the substrate.

19. Device for the production of particle beam systems (10-10"", 12-12''), with a first substrate (14), where at least one first particle beam system (10-10''''), produced by computer-guided particle beam-induced deposition, is located on the first substrate (14), **characterised in that** at least one second substrate is provided; **in that** the first and the at least one second substrate (14, 16) are arranged offset from each other in such a way that free surfaces (18-18"") of one substrate (16) are opposite the particle beam systems (10-10'''') already present on the other substrate (14), so that the particle beam systems (10-10'''') of the one substrate (14) can produce particle beam systems on the free surfaces (18-18'''') of the other substrate (16).

20. Device according to claim 19, **characterised by** a computer (20) which is programmed such that it can control the positioning of the substrates (14, 16).

21. Device according to claim 20, **characterised by** piezoelectric elements (22, 24) on the substrates (14, 16), which make it possible to position the substrates with respect to each other under computer control after evaluation of the image of the free base points.

22. Device according to one of claims 19 to 21, **characterised by** testing means, such as means for image reproduction, means for detection and display of electrical current and secondary electron values, and other display means, which are designed to test each particle beam system (10-10'''', 12-12") on the substrates (14, 16).

23. Device according to one of claims 19 to 22, **characterised in that** the first and second substrates (14, 16) are in the form of a semiconductor, especially silicon.

24. Device according to one of claims 19 to 22, **characterised in that** the first and second substrate (14, 16) is in the form of a non-conductor, especially glass, ceramic, or quartz.

25. Device according to one of claims 19 to 24, **characterised in that** the substrate has circuit elements (26), especially wiring elements (28), by means of which particle beam systems are at least partially electrically connected.

26. Device according to claim 25, **characterised in that** the circuit elements comprise in particular computer-controlled particle beam current controllers, heating current controllers, particle beam deflection amplifiers, aperture deflection amplifiers, scanner generators, function generators with memory, lens adjusting means, lens voltage amplifiers, image signal amplifiers, astigmatism voltage amplifiers, and/or deflection voltage amplifiers.

27. Device according to claim 25 or 26, **characterised in that** the circuit elements are in particular computer components such as central processing units, computer memory, cache memory, data memory, and circuits which perform routines stored in hardware, namely, the routines which make possible and are required for the reproduction of the systems, for image acquisition and evaluation, and for the production of special novel systems.

28. Device according to claim 27, **characterised in that** the circuit elements which make possible and are required for the reproduction of the systems, for image acquisition and evaluation, and for the production of special novel systems can be added sequentially by the multiplex method to the particle beam systems to be individually fabricated so that these systems can be controlled.

29. Device according to one of claims 19 to 28, **characterised in that** in order to hold a particle beam system (30), a substrate has a surface (32) with a width of approximately 2 µm to approximately 2,500 µm and a length of approximately 10 µm to approximately 100 mm.

30. Device according to one of claims 19 to 29, **characterised in that** a substrate (14) has contact points (34) for particle beam systems.

31. Device according to one of claims 19 to 30, **characterised in that** particle beam systems are arranged next to each other on a substrate similarly to the teeth of a comb.

32. Device according to one of claims 19 to 31, **characterised in that** at least one first and at least one second particle beam system are equipped with measuring and stabilising circuits, which serve to measure and to stabilise the particle beam radiation.

33. Device according to one of claims 19 to 32, **characterised in that** circuit elements are provided which supply the particle beam systems with voltage and current and which can be adjusted and programmed by data stored in memory.

34. Device according to one of claims 19 to 33, **characterised in that** the particle beam systems are provided with means designed to execute an automated testing procedure, which ensures the functionality and stability of the radiation, of image recording, and of image evaluation.

35. Device according to one of claims 19 to 34, **characterised in that** the particle beam systems are connected to image display means such as a monitor or large-format screen, where the image is divided in proportion to the individual particle beam systems, so that the work of the system can be monitored and the results made available for use elsewhere.

36. Device according to claim 35, **characterised in that** the image display means have data reduction routines to support the monitoring process and to guarantee that essentially only error data must be stored.

37. Device according to one of claims 19 to 36, **characterised in that** the particle beam systems have electron sources or gas or liquid ion sources.

38. Application of a process according to one of claims 1 to 18 and/or a device according to one of claims 19 to 37 for the production of evenly distributed components, in particular a resistance matrix for a flat camera, a flat screen with particle beam sources, lens arrays, field emitter arrays with low switching voltage to control the current, micro-electron tubes of all kinds and a read/write array for a memory.

## Revendications

1. Procédé de production de systèmes de projection corpusculaire (10-10'''', 12-12'') dans lequel au moins un premier système de projection corpusculaire (10) est produit sur un premier substrat (14), par déposition induite par projection corpusculaire, **caractérisé en ce qu'**au moins un deuxième système de projection corpusculaire (12) est produit sur au moins un deuxième substrat (16) par au moins un premier système de projection corpusculaire (10) par déposition induite par projection corpusculaire guidée par ordinateur, et ensuite au moins un autre premier système de projection corpusculaire (10') est produit sur le premier substrat par au moins un deuxième système de projection corpusculaire (12), par déposition induite par projection corpusculaire guidée par ordinateur.

2. Procédé selon la revendication 1, **caractérisé en ce que** des premiers et deuxièmes systèmes de projection corpusculaire (12', 12", 10", 10"', 10'''') sont produits en alternance par les deuxièmes et premiers systèmes de projection corpusculaire déjà existants sur les substrats (14, 16).

3. Procédé selon une des revendications 1 ou 2, **caractérisé en ce que** les premier et second substrats (14, 16) sont disposés avec décalage l'un par rapport à l'autre de manière que, face aux systèmes de projection corpusculaire (10-10'''') déjà existants sur un substrat (14), soient placées des surfaces libres (18-18'''') de l'autre substrat (16), de telle sorte que les systèmes de projection corpusculaire (10-10'''') d'un substrat (14) puissent produire des systèmes de projection corpusculaire sur les surfaces libres (18-18'''') de l'autre substrat (16).

4. Procédé selon la revendication 3, **caractérisé en ce que** les substrats (14, 16) sont positionnés sous la commande d'un ordinateur (20).

5. Procédé selon la revendication 3 ou 4, **caractérisé en ce que** les substrats (14, 16) sont positionnés l'un par rapport à l'autre au moyen d'éléments piézo-électriques (22, 24).

6. Procédé selon une des revendications précédentes, **caractérisé en ce que** chaque système de projection corpusculaire (10-10"", 12-12'') est testé électriquement après sa production.

7. Procédé selon une des revendications précédentes, **caractérisé en ce qu'**avant la production de systèmes de projection corpusculaire, on produit sur les substrats des éléments de circuits (26), en particulier des éléments de câblage (28) avec lesquels les systèmes de projection corpusculaire sont connectés électriquement au moins partiellement.

8. Procédé selon une des revendications précédentes, **caractérisé en ce qu'**on produit des systèmes de projection corpusculaire sur des points de connexion (34) qui sont prévus sur un substrat (14).

9. Procédé selon une des revendications précédentes, **caractérisé en ce que** des systèmes de projection corpusculaire sont disposés en peigne l'un à côté de l'autre sur un substrat.

10. Procédé selon une des revendications précédentes, **caractérisé en ce que** des premiers et/ou deuxièmes systèmes de projection corpusculaire exécutent une analyse d'image de signaux image qui sont produits par tramage.

11. Procédé selon une des revendications précédentes, **caractérisé en ce qu'**une focalisation, une stigmatisation et une déviation d'un faisceau corpusculaire se produisent dans un déroulement automatique et qu'une focalisation individuelle est exécutée pour chaque système de projection corpusculaire.

12. Procédé selon une des revendications précédentes, **caractérisé en ce que** la déposition est exécutée avec déposition induite par faisceau d'ions dirigé par ordinateur ou avec déposition induite par faisceau d'électrons.

13. Procédé selon une des revendications précédentes, **caractérisé en ce que** la déposition pour le premier système de projection corpusculaire à fabriquer s'effectue avec déposition microscopique spéciale tramée guidée par ordinateur, avec une basse tension d'environ 100 V à environ 40 kV.

14. Procédé selon une des revendications précédentes, **caractérisé en ce que** les systèmes de projection corpusculaire sont commandés et contrôlés en groupes par un système de commande qui comprend une électronique de commande et de programmation.

15. Procédé selon une des revendications précédentes, **caractérisé en ce que** les systèmes de projection corpusculaire sont construits à l'état entièrement configuré jusqu'à un nombre prédéterminé puis utilisés par une amenée appropriée de gaz pour la formation d'autres systèmes de projection corpusculaire réalisés sous la forme de blocs de systèmes de projection corpusculaire qui travaillent en parallèle.

16. Procédé selon la revendication 15, **caractérisé en ce que** des peignes individuels de systèmes de projection corpusculaire sont reproduits, et regroupés et configurés en systèmes de fabrication.

17. Procédé selon la revendication 15 ou 16, **caractérisé en ce que** les blocs sont produits en commun sans devoir être regroupés davantage.

18. Procédé selon une des revendications précédentes, **caractérisé en ce que** les systèmes de projection corpusculaire (voir figures 3 à 6) sont disposés avec leurs axes de faisceaux à peu près perpendiculaires à la surface du substrat.

19. Dispositif pour la production de systèmes de projection corpusculaire (10-10'''', 12-12'') comprenant un premier substrat (14), dans lequel au moins un premier système de projection corpusculaire (10-10'''') produit par déposition induite par projection corpusculaire guidée par ordinateur se trouve sur le premier substrat (14), **caractérisé en ce qu'**il est prévu au moins un deuxième substrat, le premier et au moins un deuxième substrat (14, 16) sont disposés avec décalage l'un par rapport à l'autre de manière que, face aux systèmes de projection corpusculaire (10-10'''') déjà existants sur un substrat (14), soient placées des surfaces libres (18-18'''') de l'autre substrat (16), de sorte que les systèmes de projection corpusculaire (10-10'''') d'un substrat (14) puissent produire des systèmes de projection corpusculaire sur les surfaces libres (18-18'''') de l'autre substrat (16).

20. Dispositif selon la revendication 19, **caractérisé par** un ordinateur (20) qui est aménagé par technique de programmation pour commander la disposition des substrats (14, 16).

21. Dispositif selon la revendication 20, **caractérisé par** des éléments piézo-électriques (22, 24) reliés aux substrats (14, 16) pour les positionner les uns par rapport aux autres, avec guidage par ordinateur et après l'analyse image de la reproduction des bases libres.

22. Dispositif selon une des revendications 19 à 21, **caractérisé par** des moyens de test tels que reproduction graphique, détection et affichage électrique de courants électriques et d'électrons secondaires, et autres affichages qui sont construits pour tester chaque système de projection corpusculaire (10-10'''', 12-12'') sur les substrats (14, 16).

23. Dispositif selon une des revendications 19 à 22, **caractérisé en ce que** les premier et deuxième substrats (14, 16) sont des semiconducteurs, en particulier du silicium.

24. Dispositif selon une des revendications 19 à 22, **caractérisé en ce que** les premier et second substrats (14, 16) sont des non-conducteurs, en particulier du verre, une céramique ou du quartz.

25. Dispositif selon une des revendications 19 à 24, **caractérisé en ce que** le substrat présente des éléments de circuit (26), en particulier des éléments de câblage (28), auxquels les systèmes de projection corpusculaire sont connectés électriquement, au moins en partie.

26. Dispositif selon la revendication 25, **caractérisé en ce que** les éléments de circuit comprennent en particulier un régulateur de courant de faisceau corpusculaire, régulateur de courant de chauffage, amplificateur de faisceau corpusculaire, amplificateur de déflecteur à diaphragme, générateur de trame, générateur de fonction avec mémoire, moyen de réglage de lentille, amplificateur de tension de lentille, amplificateur de signal image, amplificateur de tension d'astigmatisme et/ou amplificateur de tension de déviation, tous commandés par ordinateur.

27. Dispositif selon la revendication 25 ou 26, **caractérisé en ce que** les éléments de circuit sont en particulier des composants d'ordinateurs tels que unité centrale, mémoire de calcul, mémoire tampon, mémoire de données et des circuits exécutant des programmes enregistrés sur matériel, qui sont nécessaires pour la reproduction des systèmes, pour la saisie d'images et pour l'analyse ainsi que pour la production de systèmes spéciaux d'un nouveau genre, et qui permettent cette reproduction.

28. Dispositif selon la revendication 27, **caractérisé en ce que** les éléments de circuit qui sont nécessaires pour la reproduction des systèmes, la saisie et l'analyse d'images et pour la production de systèmes spéciaux d'un nouveau genre, et qui permettent ces opérations peuvent être activés séquentiellement dans le procédé multiplex sur les différents systèmes de projection corpusculaire à produire, pour assurer leur commande.

29. Dispositif selon une des revendications 19 à 28, **caractérisé en ce qu'**un substrat présente au moins une surface (32) d'une largeur d'environ 2 µm à environ 2500 µm et d'une longueur d'environ 10 µm à environ 100 mm pour un système de projection corpusculaire (30).

30. Dispositif selon une des revendications 19 à 29, **caractérisé en ce qu'**un substrat (14) présente des points de connexion (34) pour des systèmes de projection corpusculaire.

31. Dispositif selon une des revendications 19 à 30, **caractérisé en ce que** des systèmes de projection corpusculaire sont disposés les uns à côté des autres, en peigne, sur un substrat.

32. Dispositif selon une des revendications 19 à 31, **caractérisé en ce qu'**au moins un premier et au moins un deuxième systèmes de projection corpusculaire sont munis de circuits de mesure et stabilisateurs qui servent à la mesure et à la stabilisation d'un faisceau corpusculaire.

33. Dispositif selon une des revendications 19 à 32, **caractérisé en ce qu'**il est prévu des éléments de circuit qui alimentent les systèmes de projection corpusculaire en tension et en intensité et qui peuvent être programmés et réglés au moyen de mémoires.

34. Dispositif selon une des revendications 19 à 33, **caractérisé en ce que** les systèmes de projection corpusculaire sont munis de moyens qui sont construits pour l'exécution d'un procédé de contrôle automatisé, lequel garantit l'aptitude au fonctionnement et la stabilité de la projection, de la prise d'images et de l'analyse des images.

35. Dispositif selon une des revendications 19 à 34, **caractérisé en ce que** les systèmes de projection corpusculaire sont reliés à des moyens d'affichage d'images tels qu'un écran ou un écran large possédant un partage d'image correspondant pour les différents systèmes de projection corpusculaire, de sorte que le travail du système peut être surveillé et que son résultat peut être mis à disposition pour une utilisation ultérieure d'un autre genre.

36. Dispositif selon la revendication 35, **caractérisé en ce que** les moyens d'affichage d'images présentent des programmes de réduction de l'information de données, pour faciliter la surveillance et qui font en sorte que sensiblement seules les erreurs devront être mémorisées.

37. Dispositif selon une des revendications 19 à 36, **caractérisé en ce que** les systèmes de projection corpusculaire présentent des sources d'électrons ou des sources d'ions gazeux ou liquides.

38. Utilisation d'un procédé selon une des revendications 1 à 18 et/ou d'un dispositif selon une des revendications 19 à 37, pour la production de composants étendus plats, en particulier d'une matrice de résistances pour une caméra plate, un écran plat possédant des sources de faisceaux corpusculaires, de matrices de lentilles, ou de matrices d'émetteurs à haute tension, possédant une faible tension de commutation pour la commande du courant, de tubes micro-électroniques de tout genre et d'un dispositif d'écriture/lecture pour une mémoire.
